# EUROPEAN PATENT SPECIFICATION

(11) **EP 2 301 069 B1**
(45) Date of publication and mention of the grant of the patent: **25.01.2012**
(21) Application number: 09754364.9
(22) Date of filing: 27.05.2009
(51) Int. Cl.: H01L 21/368, H01L 21/02

(54) **MICRO EMULSION OF CADMIUM TELLURIDE AND PREPARATION METHOD**
MIKROEMULSION VON CADMIUM TELLURID UND HERSTELLUNGSVERFAHREN
MICRO-ÉMULSION DE TELLURURE DE CADMIUM ET SON PROCÉDÉ DE PRÉPARATION

(30) Priority: 28.05.2008 IT CS20080009
(43) Date of publication of application: 30.03.2011
(73) Proprietor: Alvaro, Ines, 89048 Siderno (RC) (IT); Ceva, Giacomo, 89900 Vibo Valentia (IT); De Girolamo, Franco, 00193 Roma (IT); Futia, Michele, 89048 Siderno (RC) (IT); Romeo, Giuseppe, 89034 Bovalino (RC) (IT)
(72) Inventor: CEVA, Giacomo, I-89900 vibo Valentia (IT)
(74) Representative: Perrotta, Aldo
(86) International application number: PCT/IT2009/000231
(87) International publication number: WO 2009/144762

(56) References cited:
- WO-A2-2007/117668
- FR-A1- 2 892 563
- YANG D ET AL: "Electrostatic assembles and optical properties of Au-CdTe QDs and Ag/Au-CdTe QDs" PHYSICA E - LOW-DIMENSIONAL SYSTEMS AND NANOSTRUCTURES, ELSEVIER SCIENCE BV, NL, vol. 40, no. 10, 22 April 2008 (2008-04-22), pages 3072-3077, XP024523840 ISSN: 1386-9477 [retrieved on 2008-04-22]

## Description

### Technical field of the invention.

The present invention concerns the production of micro-emulsions of cadmium telluride and a method for its preparation, in order for its use, in particular, for high-efficiency photovoltaic panel films, that is those able to produce greater electrical energy from a comparable area.

### State of the Art

The use of tellurium of cadmium (CdTe) film to produce solar cells of fine film is known in the state of the art, and various methods have been used to obtain high-efficiency solar cells.

In the international patent request WO03032406 a method is described in which the preparation of CdTe/CdS solar cells is carried out by treating the CdTe with CdCl₂. The layer of CdTe is applied by atomization.

The treatment of CdTe with CdCl₂ includes the following steps: a layer of CdCl₂ on the CdTe film is formed by evaporation, while the substrate is maintained at room temperature, the CdCl₂ is eliminated in a vacuum chamber at 380 - 420° C and 300 - 1000 hPa in an atmosphere of inert gasses, removing the inert gasses from said chamber to produce the vacuum state, while the substrate is maintained at a temperature of 350 - 420° C while all CdCl₂ residue is evaporated from the surface of the CdTe film. Posterior contact is obtained by atomizing 150 nm of Sb₂Te and 150 nm of Mo.

After one hour under 10 suns at a temperature of 180°C in open circuit conditions the solar cell prepared in the way described in WO03032406 gave the following parameters:

| | |
|---|---|
| Voc = | 852 mV |
| Jsc= | 25 mA/cm2 |
| ff = | 0,66 |
| Efficienza = | 14 % |
| Voc = | 852 mV |
| Jsc= | 25 mA/cm2 |
| ff = | 0,66 |
| Efficiency = | 14 % |

Although the method described in WO03032406 represents a step forward in the production of fine films for solar cells, it has the disadvantage of having a limited efficiency and needing expensive equipment for laying the CdTe film and even more expensive equipment for the treatment of the CdTe film with CdCl₂.

The principal aim of the present invention is that of obtaining, by a simple and reproducible method, a micro-emulsion of CdTe, easily applicable both with normal serigraphy equipment as well as with spray layering or ink-jet techniques.

Another main aim is that of obtaining a fine film that in standard trial conditions is capable of showing a high level of efficiency improved by 40%.

### Description of the preferred method of creation.

The preparation of nano-crystals of cadmium telluride has been chemically experimented and it has been seen that the use of micro-emulsion systems constitutes a rapid and efficient method in the production of semi-conductors.

A micro-emulsion is a homogenous dispersion of two un-mixable liquids, transparent and isotropic, mediated by a particular class of molecule. A micro-emulsion, therefore, is formed of aggregates of pseudo-spherical structure, constituted of micro-droplets with diameters that reach 200 nm at most, approximately 100 times smaller than the dimensions of a classic emulsion.

Micro-emulsions are constituted of micelles with polar heads directed towards the inside of the aggregate, and which form a polar heart which can solubilize.

Because of the limited dimensions of the micelle aggregates, the micro-emulsions are stable systems. In general, the particles prepared in micro-emulsion are characterised by having, on average, very small dimensions; a very limited distribution of dimensions and a high level of stability in the systems.

This technique offers numerous advantages: small and sufficiently monodispersed particles can be obtained; the dimensions of the particles can be modulated by varying the experimental parameters of the micro-emulsion. The use of micelles does not necessitate particular conditions of pressure and temperature, and allows the creation of an organic or inorganic capping of the nano-crystal semi-conductor.

The method of the present invention foresees the following steps:
a) the cadmium telluride is finely pulverised.
b) the same product is humidified with Aqua Regia, constituted of three parts of concentrated hydrochloric acid and one part of concentrated nitric acid.
c) into the cadmium telluride, kept in movement by an agitator, a polymer or a monomer is incorporated.
d) while always maintaining the whole in movement, an alkyl ester is mixed with a reactor, constituted of a mixture of liquefied crystals coming from germanium or another semi-metal. Said crystals are indispensable for obtaining a high level of efficiency, which was visible at the end of the trials.

A Micro emulsion of cadmium telluride is obtained which is ready to be applied as a film for the production of semi-conductor devices, in particular photo-voltaic cells containing liquefied semi-metal crystals, germanium in particular. The crystals have dimensions that are inferior to 200 nm, in particular between 10 and 100 nm. The best method for laying or applying the deposit of the products is on chosen supports.

All the serigraphy techniques have been thoroughly examined and applied, and no difficulty was encountered either with the composites or with the whole in application onto supports with different characteristics, of any thickness, for example: plastic, rubber, acetate, ceramic tiles, etc., the semi-conductors created by the described method and the films applied to the same had no variation in efficiency.

The films produced by the described method have been tried and tested according the present regulations governing certification.

The test was carried out with an I-V Test Analyser, the electrical connection of the sample according to the UNI 60904-1 regulation and a junction temperature sensor. The sample was irradiated by a class C simulator (with a uniformity of illumination onto the surface of the model of less than 10%) with an incident spectrum conditioned by an AM 1.5 filter and an angle of incidence of 45° on the horizontal plane.

The results obtained were the following:

| | | |
|---|---|---|
| lsc: | 862.16 | [mA] |
| Voc: | 2.96 | [V] |
| Pmax: | 2273.7 | [mW] |
| Ipmax: | 811.06 | [mA] |
| Vpmax: | 2.8034 | [V] |
| PI: | 2117.9 | [mW] |
| 11 : | 836.61 | [mA] |
| F.F: | 0.891 | |
| Eff: | 45.474 | [%] |
| T.mea: | 24 | [°C] |

## Claims

1. A method for the preparation of a micro emulsion of cadmium telluride, ready for application as a film for semiconductor devices , **characterised by** the fact that the method foresees the following steps:
a) the cadmium telluride is pulverised into particles of dimensions less than 200 nm,
b) said cadmium telluride is humidified with Aqua regia, constituted of three parts of concentrated hydrochloric acid and one part concentrated nitric acid,
c) to the cadmium telluride, maintained in movement by an agitator, a polymer or a monomer is incorporated,
d) while keeping the whole constantly agitated, an Alkyl ester is added, which is mixed with a reagent constituted of a mixture of liquefied crystals of semi-metals.

2. Method for the preparation of a micro emulsion of cadmium telluride prepared according to the preceding claim, **characterised by** the fact that the semi-metal is germanium.

## Patentansprüche

1. Verfahren zur Herstellung eines Mikro-Emulsion von Cadmium-Tellurid, bereit für den Einsatz als Folie für Halbleiterbauelemente, **dadurch gekennzeichnet, dass** das Verfahren beinhaltet die folgenden Schritte:
a) das Cadmium-Tellurid ist in Partikel von weniger als 200 nm pulverisiert;
b) das Cadmium-Tellurid wird befeuchtet mit Königswasser, bestehend aus drei Teilen konzentrierter Salzsäure und einem Teil konzentrierter Salpetersäure;
c) der Cadmium-Tellurid, gehalten in Bewegung durch einen Rührer, ein Polymer oder ein Monomer ist eingebaut;
d) während die ganze permanent aufgewühlt, ist ein Alkylester hinzu, die mit einem Reagenz, das aus einer Mischung aus verflüssigtem Kristalle von Halbmetall vermischt.

2. Verfahren zur Herstellung eines Mikro-Emulsion von Cadmium-Tellurid hergestellt nach dem vorhergehenden Anspruch, **dadurch gekennzeichnet, dass** das Halbmetall aus Germanium ist.

## Revendications

1. Méthode pour la préparation d'une micro-émulsion de tellurure de cadmium, prêt pour l'application comme un film pour dispositifs semi-conducteurs, **caractérisée par le fait que** la méthode prévoit les étapes suivantes:
a) le tellurure de cadmium est pulvérisé en particules de dimensions inférieures à 200 nm ;
b) ledit tellurure de cadmium est humidifié avec eau régale, constitué de trois parties d'acide chlorhydrique concentré et une partie d'acide nitrique concentrée ;
c) au tellurure de cadmium, maintenu en mouvement par un agitateur, un polymère ou un monomère est incorporé ;
d) tandis que l'ensemble constamment agité, un ester d'alkyle est ajouté, ce qui est mélangé à un réactif constitué d'un mélange de cristaux liquides de semi-métaux.

2. Méthode pour la préparation d'une micro-émulsion de tellurure de cadmium préparés selon la revendication précédente, **caractérisée par le fait que** le semi-métal est le germanium.
